Europäisches Patentamt

European Patent Office

Office européen des brevets

(19)

(11) Veröffentlichungsnummer: **0 145 954**
**A2**

# (12) EUROPÄISCHE PATENTANMELDUNG

(21) Anmeldenummer: 84113669.0

(22) Anmeldetag: 13.11.84

(51) Int. Cl.⁴: **H 05 K 5/02**

(30) Priorität: 15.11.83 DE 8332758 U

(43) Veröffentlichungstag der Anmeldung: 26.06.85
**Patentblatt 85/26**

(84) Benannte Vertragsstaaten: **AT BE CH DE FR GB IT LI LU NL SE**

(71) Anmelder: **Rittal-Werk Rudolf Loh GmbH & Co. KG, Auf dem Stützelberg, D-6348 Herborn (DE)**

(72) Erfinder: **Berg, Franco, Am Walde 2, D-3004 Isernhagen (DE)**

(74) Vertreter: **Vogel, Georg, Hermann-Essig-Strasse 35, D-7141 Schwieberdingen (DE)**

(54) Vorrichtung zum Befestigen eines Lagerbolzens einer Lagerwelle und dgl. an einer Befestigungsleiste.

(57) Die Erfindung betrifft eine Vorrichtung zum Befestigen eines Lagerbolzens, einer Lagerwelle und dgl. an einer mit einer Lochreihe versehenen Befestigungsleiste, insbesondere einer an einer Schaltschrankwand angebrachten und im Abstand parallel zu dieser Schaltschrankwand ausgerichteten Befestigungsleiste. Ein leichtes und schnelles Anbringen und Lösen der Vorrichtung wird dadurch erreicht, daß das Ende des Lagerbolzens, der Lagerwelle und dgl. in die Bohrung eines Lagerbockes eingeführt ist, daß der Lagerbock parallel zur Bohrung eine Auflagefläche mit Zentrierzapfen zum fixierten Festlegen an der Befestigungsleiste aufweist und daß der Auflagefläche gegenüber an einem Flansch des Lagerbockes ein Spannhebel drehbar gelagert ist, der mit einem Spannexzenter die Befestigungsleiste gegen die Auflagefläche des Lagerbockes verspannt.

0145954

Vorrichtung zum Befestigen eines Lagerbolzens,
einer Lagerwelle und dgl. an einer Befestigungsleiste

Die Erfindung betrifft eine Vorrichtung zum Befestigen eines Lagerbolzens, einer Lagerwelle und dgl. an einer mit einer Lochreihe versehenen
Befestigungsleiste, insbesondere einer an einer Schaltschrankwand angebrachten und im Abstand parallel zu dieser Schaltschrankwand ausgerichteten Befestigungsleiste.

Wie das DE-GM 83 10 783 zeigt, kann mit einer derartigen Vorrichtung
z.B. die Lagerwelle eines klappbaren Arbeitstisches an den Befestigungsleisten eines Schaltschrankes festgemacht werden. Die dabei verwendeten
und mit der Befestigungsleiste verschraubten Lagerelemente für die
Lagerwelle sind dann ausreichend, wenn die Lagerwelle dauernd an der
einmal gewählten Stelle der Befestigungsleiste verbleibt. Sollen jedoch
die Lagerelemente der Lagerwelle schnell und leicht gelöst und wieder an
anderer Stelle der Befestigungsleiste oder an anderen Befestigungsleisten angebracht werden, dann sind die bekannten Lagerelemente nicht
geeignet, da sie sowohl für das Lösen, als auch das Wiederanbringen
einen beachtlichen Arbeitsaufwand erfordern.

Es ist Aufgabe der Erfindung, eine Vorrichtung der eingangs erwähnten
Art zu schaffen, bei der mit einfachen Bedienungsmaßnahmer das Ende
eines Lagerbolzens, einer Lagerwelle und dgl. schnell an einer mit einer
Lochreihe versehenen Befestigungsleiste angebracht und auch wieder
schnell von dieser Befestigungsleiste gelöst werden kann.

Diese Aufgabe wird nach der Erfindung dadurch gelöst, daß das Ende des Lagerbolzens, der Lagerwelle und dgl. in die Bohrung eines Lagerbockes eingeführt ist, daß der Lagerbock parallel zur Bohrung eine Auflagefläche mit Zentrierzapfen zum fixierten Festlegen an der Befestigungsleiste aufweist und daß der Auflagefläche gegenüber an einem Flansch des Lagerbockes ein Spannhebel drehbar gelagert ist, der mit einem Spannexzenter die Befestigungsleiste gegen die Auflagefläche des Lagerbockes verspannt.

Der Lagerbock wird mit der Auflagefläche an die gewünschte Stelle der Befestigungsleiste angebracht, wobei die Zentrierzapfen eine stufige Verstellung zulassen, die durch die Lochteilung der Lochreihe bestimmt ist. Der Spannhebel braucht dann nur in die Spannstellung verdreht zu werden, so daß der Spannexzenter die Verspannung zwischen der Auflagefläche des Lagerbockes und der Befestigungsleiste vornimmt. Beim Aufheben der Befestigungsstelle wird der Spannhebel wieder in die Entspannstellung gebracht. Das Herstellen und das Lösen des Lagerbockes erfordert nur eine einzige einfache Bedienungsmaßnahme.

Ist die Befestigungsleiste L- oder Z-förmig und fest mit der Schaltschrankwand verbunden, ist nach einer Ausgestaltung vorgesehen, daß die Dicke des Lagerbockes kleiner ist als der Abstand der Befestigungsleiste von der Schaltschrankwand, damit der Lagerbock zwischen der Schaltschrankwand und der Befestigungsleiste eingeführt werden kann und der Spannhebel von der leicht zugänglichen Vorderseite her bedient werden kann.

Der Lagerbock kann auf einfache Weise dadurch unverlierbar auf dem Ende des Lagerbolzens, der Lagerwelle und dgl. festgelegt werden, daß der Lagerbolzen, die Lagerwelle am Ende eine Ringnut trägt und daß der Lagerbock mit einer quer zur Bohrung verlaufenden und diese Bohrung anschneidenden Querbohrung für einen in die Ringnut des eingesetzten Lagerbolzens, der eingesetzten Lagerwelle und dgl. eingreifenden Stift versehen ist. Der Stift legt den Lagerbock axial unverschiebbar auf dem Lagerbolzen, der Lagerwelle und dgl. fest. Der Lagerbolzen, die Lagerwelle und dgl. kann jedoch nach wie vor in der Bohrung des Lagerbockes verdreht werden.

Die Drehlagerung des Spannhebels mit dem Spannexzenter ist nach einer Ausgestaltung so ausgeführt, daß der Spannhebel mit dem Spannexzenter auf einem an dem Flansch angeformten Hohlzapfen drehbar gelagert und mittels eines mit Kopf versehenen und in den Hohlzapfen eingesteckten Haltebolzens auf dem Hohlzapfen gehalten ist.

Ist nach einer weiteren Ausgestaltung vorgesehen, daß die Aufnahme im Spannexzenter für den Hohlzapfen des Lagerbockes mit einem zum Spannhebel gerichteten Schlitz versehen ist, dann kann der Spannhebel auf dem Hohlzapfen unter Spannung gehalten werden, so daß er seine eingestellte Stellung beibehält.

Die Anordnung des Flansches am Lagerbock ist nach einer Ausgestaltung so, daß der Flansch bündig mit einer mit der Bohrung versehenen Seite des Lagerbockes ist, daß an dieser Seite des Lagerbockes ein Bund um die Bohrung angeordnet ist und daß der Hohlzapfen auf der gegenüberliegenden Seite des Flansches angeformt ist. Auf diese Weise kann der Lagerbock klein gehalten werden und bietet dann eine ausreichende Auflagefläche für die Befestigungsleiste, wenn zusätzlich vorgesehen ist, daß die Auflagefläche des Lagerbockes an den Flansch anschließt und mit mindestens zwei Zentrierzapfen versehen ist, die auf die Lochteilung und Lochabmessung der Lochreihe der Befestigungsleiste abgestimmt und auf einer Linie parallel zum Flansch angeordnet sind. Dabei ist bevorzugt vorgesehen, daß die Auflagefläche des Lagerbockes und der Spannexzenter gleich breit sind.

Das Aufstecken des Lagerbockes auf die Befestigungsleiste wird nach einer Ausgestaltung dadurch erleichtert, daß der Spannexzenter auf der dem Spannhebel abgekehrten Seite eine Abflachung aufweist, die in der Stellung des Spannhebels senkrecht zur Auflagefläche des Spannbockes in einem Abstand zu den Zentrierzapfen steht, der größer ist als die Dicke der Befestigungsleiste.

Eine weitere Befestigungsmöglichkeit für den Lagerbock ergibt sich nach einer Weiterbildung dadurch, daß der Lagerbock von der der Auflagefläche gegenüberliegenden Seite ausgehende und auf die Zentrierzapfen ausgerichtete, sacklochartige Befestigungsaufnahmen aufweist. Da dann der Spannhebel mit dem Spannexzenter nicht benötigt wird, kann vorgesehen sein, daß der Lagerbock bei abgenommenem Spannhebel mit Spannexzenter mittels einer Abdeckkappe von dieser Seite her abdeckbar ist, wobei der Rand der Abdeckkappe mit einem portalartigen Teilabschnitt den portalartigen Flansch und den Lagerbock seitlich umschließt, während ein geradliniger Teilabschnitt die Seite des Lagerbockes mit den Befestigungsaufnahmen abdeckt, jedoch mit Bohrungen versehen ist, die mit den Befestigungsaufnahmen des Lagerbockes fluchten.

Die Erfindung wird anhand eines in den Zeichnungen dargestellten Ausführungsbeispiels näher erläutert. Es zeigt:

Fig. 1 in Seitenansicht eine Lagerwelle, die mittels eines Lagerbockes mit Spannhebel an einer Befestigungsleiste festgelegt wird,

Fig. 2 in Frontansicht und teilweise im Schnitt die Befestigungsstelle nach Fig. 1,

Fig. 3 in Draufsicht die Befestigungsstelle nach Fig. 1,

Fig. 4 eine Abdeckkappe zur Abdeckung des Lagerbockes und

Fig. 5 den Lagerbock ohne Spannhebel auf einer Lagerwelle.

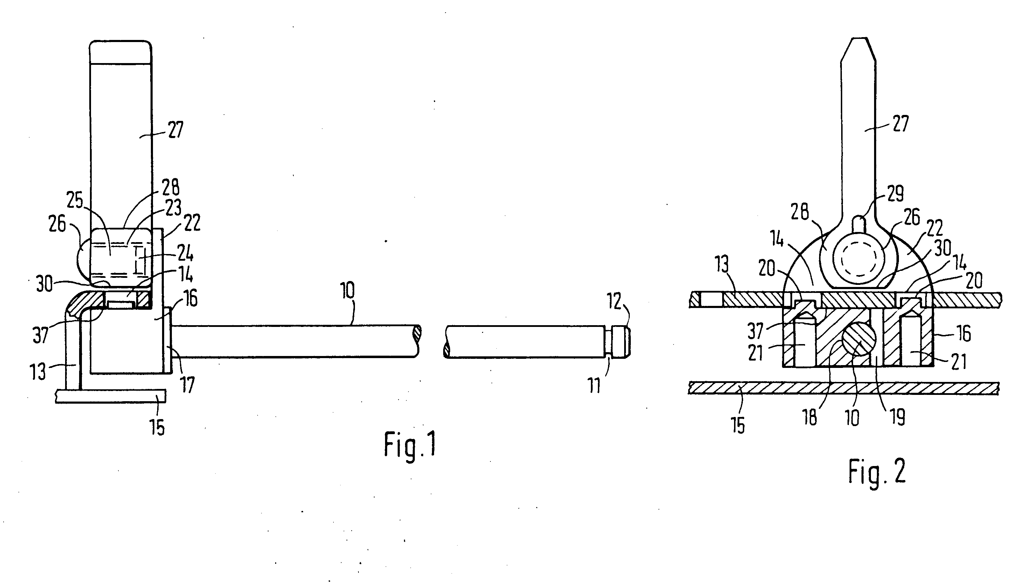

Bei dem Ausführungsbeispiel nach den Fig. 1 bis 3 wird eine Lagerwelle 10 an beiden Enden mit einer Befestigungsleiste verbunden. Das mit der Einfuhrschräge 12 versehene Ende der Lagerwelle 10 trägt eine Ringnut 11, wie das rechte Ende der Lagerwelle 10 in Fig. 1 erkennen läßt. Das Ende der Lagerwelle 10 wird in die Bohrung 18 des Lagerbockes 16 eingeführt. In die Querbohrung 19, die die Bohrung 18 anschneidet, wird ein Stift eingeführt, der in die Ringnut 11 eingreift und so den Lagerbock 16 axial unverschiebbar, jedoch drehbar auf der Lagerwelle 10 festlegt. Der Lagerbock 16 wird so auf die Lagerwelle 10 aufgebracht, daß die Seite mit dem Bund 17 um die Bohrung 18 der Mitte der Lagerwelle 10 zugekehrt ist. Der Bund 17 verhindert, daß Teile, die auf der Lagerwelle 10 aufgebracht sind, großflächig am Lagerbock 16 anliegen. An der Seite mit dem Bund 17 ist der Flansch 22 bündig angefcrmt. Der Flansch 22 steht senkrecht zu der als Auflagefläche 37 wirkenden Oberseite des Lagerbockes 16 und schließt unmittelbar an diese Auflagefläche 37 an. Die Auflagefläche 37 weist zwei Zentrierzapfen 20 auf, die auf die Lochteilung und Lochabmessung der Lochreihe 14 der Befestigungsleiste 13 abgestimmt sind. Damit läßt sich der Lagerbock 16 in der durch die Lochteilung vorgegebenen Abstufung an der Befestigungsleiste 13 fixieren. Die Zentrierzapfen 20 werden dabei in die Löcher der Lochreihe 14 eingeführt.

An der der Auflagefläche 37 zugekehrten Seite des Flansches 22 ist der Hohlzapfen 23 mit seiner Innenaufnahme 24 angefcrmt. Auf diesem Hohlzapfen 23 wird der Spannhebel 27 mit dem Spannexzenter 28 drehbar gelagert. Wie die Fig. 1 zeigt, hat der Spannexzenter 28 dieselbe Breite wie die Auflagefläche 37. Der Spannexzenter 28 hat eine Aufnahme, die den Hohlzapfen 23 aufnimmt. Der Haltebolzen 25 wird in die Innenaufnahme 24 des Hohlzapfens 23 eingesteckt und der Kopf 26 des Haltebolzens 25 hält den Spannexzenter 28 auf dem Hohlzapfen 23 fest. Die Aufnahme im Spannexzenter 28 weist den Schlitz 29 auf, der in Richtung des Spannhebels 27 gerichtet ist. Damit kann der Spannexzenter 28 unter Spannung auf dem Hohlzapfen 23 gehalten werden, so daß die eingestellte Stellung des Spannhebels 27 aufrechterhalten bleibt.

Der Spannexzenter 28 weist auf der dem Spannhebel 27 abgekehrten Seite die Abflachung 30 auf, die in der in Fig. 2 gezeigten Stellung des Spannhebels 27 parallel zur Auflagefläche 37 des Spannblockes 16 verläuft und in einem Abstand zu den Zentrierzapfen 20 steht, der größer ist als die Dicke der Befestigungsleiste 13. In dieser Stellung kann die Befestigungsleiste 13 in den Raum zwischen der Auflagefläche 37 und der Abflachung 30 des Spannexzenters 28 eingebracht werden. Die Höhe der Zentrierzapfen 20 kann klein gehalten werden, da sie zur Fixierung der Befestigungsleiste 13 nur teilweise in die Löcher der Lochreihe 14 ragen müssen.

Wird der Spannhebel 27 aus der senkrechten Stellung verdreht, dann wird der Spannexzenter 28 die Befestigungsleiste 13 gegen die Auflagefläche 37 des Lagerbockes 16 verspannen. Die Spannkurve des Spannexzenters 28 kann dabei so ausgelegt sein, daß der Spannexzenter 28 sich selbsthemmend an der Befestigungsleiste 13 abstützt.

Die Befestigungsleiste 13, die L- oder Z-förmig sein kann, ist an der Schaltschrankwand 15 so befestigt, daß der Schenkel mit der Lochreihe 14 parallel und im Abstand zur Schaltschrankwand 15 verläuft. Damit der Lagerbock 16 leicht auf die Befestigungsleiste 13 aufgeschoben werden kann, wird die Dicke des Lagerbockes 16 kleiner als der Abstand der Befestigungsleiste 13 von der Schaltschrankwand 15 gewählt.

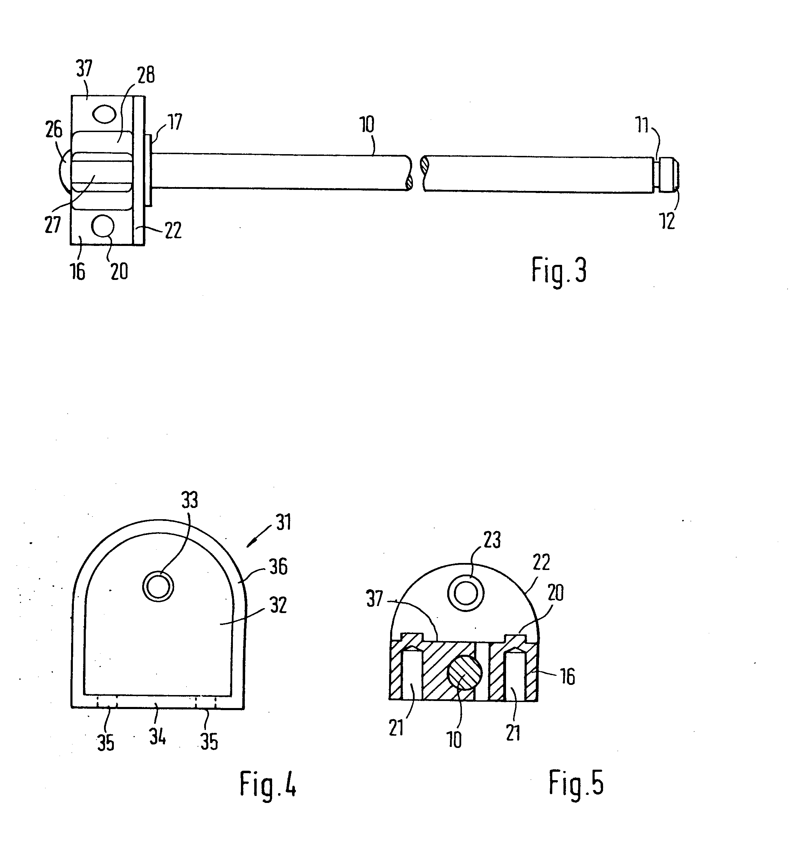

Die der Auflagefläche 37 abgekehrte Seite des Lagerbockes 16 trägt weitere Befestigungsaufnahmen 21, die z.B. als Sacklochbohrungen oder Sacklochgewindebohrungen ausgebildet sein können. Diese Befestigungsaufnahmen 21 erlauben eine direkte Befestigung des Lagerbockes 16 auf der Schaltschrankwand 15. Da dann der Spannhebel 27 mit dem Spannexzenter 28 nicht benötigt wird, wird der Lagerbock 16 bei abgenommenem Spannhebel 27 nach Fig. 5 mittels einer Abdeckkappe 31 nach Fig. 4 abgedeckt. Der Rand der Abdeckkappe 31 hat den portalartigen Abschnitt 36 und den geraden Abschnitt 34, die den Lagerbock 16 mit dem portalartigen Flansch 22 so umschließen, daß die Seite mit dem Bund 17 bündig mit dem Rand der Abdeckkappe 31 abschließt. Der Hohlzapfen 23 nimmt mit seiner Innenaufnahme 24 einen auf der Innenseite der Abschlußwand 32 der Abdeckkappe 31 angeformten Befestigungszapfen 33 auf. Der Abschnitt 34 des Randes hat Bohrungen 35, die mit den Befestigungsaufnahmen 21 des Lagerbockes 16 fluchten. Mit den Befestigungsschrauben, die in die Befestigungsaufnahmen 21 eingeführt und eingeschraubt werden, werden der Lagerbock 16 und die Abdeckkappe 31 zusammen an der Schaltschrankwand 15 befestigt. Die Abdeckkappe 31 deckt die Auflagefläche 37 und den Hohlzapfen 23 des Lagerbockes 16 ab, so daß ein geschlossenes Lagerelement entsteht.

0145954

Rittal - Werk
Rudolf Loh GmbH & Co. KG
Auf dem Stützelberg

6348 H e r b o r n

- 1 -

<u>A n s p r ü c h e</u>

1. Vorrichtung zum Befestigen eines Lagerbolzens, einer Lagerwelle
   und dgl. an einer mit einer Lochreihe versehenen Befestigungsleiste, insbesondere einer an einer Schaltschrankwand angebrachten
   und im Abstand parallel zu dieser Schaltschrankwand ausgerichteten
   Befestigungsleiste,
   dadurch gekennzeichnet,
   daß das Ende des Lagerbolzens, der Lagerwelle (10) und dgl. in die
   Bohrung (18) eines Lagerbockes (16) eingeführt ist,
   daß der Lagerbock (10) parallel zur Bohrung (18) eine Auflagefläche (37) mit Zentrierzapfen (20) zum fixierten Festlegen an der
   Befestigungsleiste (13) aufweist und
   daß der Auflagefläche (37) gegenüber an einem Flansch (22) des
   Lagerbockes (10) ein Spannhebel (27) drehbar gelagert ist, der mit
   einem Spannexzenter (28) die Befestigungsleiste (13) gegen die
   Auflagefläche (37) des Lagerbockes (16) verspannt.

2. Vorrichtung nach Anspruch 1,
   dadurch gekennzeichnet,
   daß die Dicke des Lagerbockes (16) kleiner ist als der Abstand der
   Befestigungsleiste (13) von der Schaltschrankwand (15).

3.  Vorrichtung nach Anspruch 1 oder 2,
    dadurch gekennzeichnet,
    daß der Lagerbolzen, die Lagerwelle (10) am Ende eine Ringnut (11)
    trägt und
    daß der Lagerbock (16) mit einer quer zur Bohrung (18) verlaufenden und diese Bohrung (18) anschneidenden Querbohrung (19) für
    einen in die Ringnut (11) des eingesetzten Lagerbolzens, der
    eingesetzten Lagerwelle (10) und dgl. eingreifenden Stift versehen
    ist.

4.  Vorrichtung nach einem der Ansprüche 1 bis 3,
    dadurch gekennzeichnet,
    daß der Spannhebel (27) mit dem Spannexzenter (27) auf einem an
    dem Flansch (22) angeformten Hohlzapfen (23) drehbar gelagert und
    mittels eines mit Kopf (26) versehenen und in den Hohlzapfen (23)
    eingesteckten Haltebolzens (25) auf dem Hohlzapfen (23) gehalten
    ist.

5.  Vorrichtung nach Anspruch 4,
    dadurch gekennzeichnet,
    daß die Aufnahme im Spannexzenter (28) für den Hohlzapfen (23) des
    Lagerbockes (16) mit einem zum Spannhebel (27) gerichteten Schlitz
    (29) versehen ist.

6.  Vorrichtung nach einem der Ansprüche 1 bis 5,
    dadurch gekennzeichnet,
    daß der Flansch (22) bündig mit einer mit der Bohrung (18) versehenen Seite des Lagerbockes (16) ist,
    daß an dieser Seite des Lagerbockes (16) ein Bund (17) um die
    Bohrung (18) angeordnet ist und
    daß der Hohlzapfen (23) auf der gegenüberliegenden Seite des
    Flansches (22) angeformt ist.

7.  Vorrichtung nach einem der Ansprüche 1 bis 6,
    dadurch gekennzeichnet,
    daß die Auflagefläche (37) des Lagerbockes (16) an den Flansch
    (22) anschließt und mit mindestens zwei Zentrierzapfen (20) versehen ist, die auf die Lochteilung und Lochabmessung der Lochreihe
    (14) der Befestigungsleiste (13) abgestimmt und auf einer Linie
    parallel zum Flansch (22) angeordnet sind.

8.  Vorrichtung nach einem der Ansprüche 1 bis 7,
    dadurch gekennzeichnet,
    daß die Auflagefläche (37) des Lagerbockes (16) und der Spannexzenter (28) gleich breit sind.

9.  Vorrichtung nach einem der Ansprüche 1 bis 8,
    dadurch gekennzeichnet,
    daß der Spannexzenter (28) auf der dem Spannhebel (27) abgekehrten
    Seite eine Abflachung (30) aufweist, die in der Stellung des
    Spannhebels (27) senkrecht zur Auflagefläche (37) des Spannbockes
    (16) in einem Abstand zu den Zentrierzapfen (20) steht, der größer
    ist als die Dicke der Befestigungsleiste (13).

10. Vorrichtung nach einem der Ansprüche 1 bis 9,
    dadurch gekennzeichnet,
    daß der Lagerbock (16) von der der Auflagefläche (37) gegenüberliegenden Seite ausgehende und auf die Zentrierzapfen (20) ausgerichtete, sacklochartige Befestigungsaufnahmen (21) aufweist.

11. Vorrichtung nach einem der Ansprüche 1 bis 10,
    dadurch gekennzeichnet,
    daß der Lagerbock (16) bei abgenommenem Spannhebel (27) mit Spannexzenter (28) mittels einer Abdeckkappe (31) von dieser Seite her
    abdeckbar ist, wobei der Rand der Abdeckkappe (31) mit einem

0145954

portalartigen Teilabschnitt (36) den portalartigen Flansch (22)
und den Lagerbock (16) seitlich umschließt, während ein geradliniger Teilabschnitt (34) die Seite des Lagerbockes (16) mit den
Befestigungsaufnahmen (21) abdeckt, jedoch mit Bohrungen (35)
versehen ist, die mit den Befestigungsaufnahmen (21) des Lagerbockes (16) fluchten.

Fig.1

Fig. 2

0145954

Fig.3

Fig.4

Fig.5